Europäisches Patentamt

European Patent Office

Office européen des brevets

(11) Publication number: **0 099 426**
**B1**

(12) **EUROPEAN PATENT SPECIFICATION**

(45) Date of publication of patent specification: **13.05.87**

(21) Application number: **82201679.6**

(22) Date of filing: **30.12.82**

(51) Int. Cl.⁴: **G 03 F 7/16**

(54) **A process for coating a liquid photopolymerizable composition and a process for producing a printed circuit board thereby.**

(30) Priority: **19.07.82 JP 125312/82**
**19.07.82 JP 125313/82**

(43) Date of publication of application:
**01.02.84 Bulletin 84/05**

(45) Publication of the grant of the patent:
**13.05.87 Bulletin 87/20**

(84) Designated Contracting States:
**BE DE FR GB IT NL**

(56) References cited:
**DE-A-2 614 525**
**FR-A-2 047 506**
**GB-A-1 310 126**
**US-A-3 687 785**
**US-A-4 087 182**

(73) Proprietor: **Asahi Kasei Kogyo Kabushiki Kaisha**
**2-6, Dojimahama 1-chome Kita-ku**
**Osaka-shi Osaka 530 (JP)**

(72) Inventor: **Kawatsuji, Shin'ichi**
**186-7, Gokanjima**
**Fuji-shi Shizuoka-ken (JP)**
Inventor: **Yamagata, Takeshi**
**25-12, Kiyogawacho**
**Hachioji-shi Tokyo-to (JP)**

(74) Representative: **Hatzmann, Marinus Jan c/o**
**Vereenigde Octrooibureaux et al**
**Nieuwe Parklaan 107**
**NL-2587 BP The Hague (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to a process for uniformly and efficiently coating a liquid photopolymerizable composition onto the surface of a base material, and to a process for further producing a photoresist image, a printed circuit board having through-holes or a solder mask by exposing the composition to a light and removing unhardened areas of the composition with a developing solution.

Recently, a photopolymerizable composition has become to be used in various fields including relief printing. For instance, some kinds of photopolymerizable composition are used as photoresists for producing a printed circuit board which is useful in the electronic industry.

Generally, a printed circuit board is produced as follows. A liquid photopolymerizable composition suitable for producing a printed circuit board is applied, in a thickness as uniform as possible, to a base material consisting of a laminated board clad with an electro-conductive metal such as copper. After an image-bearing transparency such as a negative film has been placed on the layer of the liquid photopolymerizable composition, the layer is exposed to actinic light through the transparency whereby areas of the layer are polymerized and photohardened thus being made insoluble to a solution which dissolves unhardened areas of the layer and to a solution which etches an electro-conductive metal. Then, after the image-bearing transparency has been peeled off from the photohardened resin layer, the composition in the areas not photohardened is removed in a developing step.

In a further step the laminated board is etched to dissolve and remove the portions of electro-conductive metal exposed in the areas where the non-hardened composition has been removed.

The remaining photohardened resin is then stripped by a stripping solution such as methylene chloride and in this way a printed circuit board can be made.

The photopolymerizable composition for producing a printed circuit board as described above can be applied in the solid form, as a film or sheet previously made, or in the liquid form, which will be applied to the base material just prior to use.

When the photopolymerizable composition applied in the form of a solid sheet or film, the sheet of film is formed so as to have almost uniform thickness and hence has a good processability. However, it is not always possible for portions of the composition not exposed to light to be removed in a removing step with a developing solution and reused. So the material removed is wasted, which is uneconomic.

Further it is necessary to heat the sheet or film and the base material in order to make the composition adhere to the base, and hence heating apparatus will be necessary, which increases the cost of the equipment required.

Furthermore, in order to develop sufficient adhesive strength the sheet or film and the base material they should be held together for a certain time after lamination, so that the work cannot be carried out continuously and with efficiency.

Also, unless the surface of the base is perfectly smooth and clean, adherence will be defective and blisters may be formed.

Accordingly, applying the photopolymerizable composition in the form of a solid sheet or film has various drawbacks.

On the other hand, when a liquid photopolymerizable composition is used after the composition has been applied to a base and exposed to light, a portion of the composition which has not been exposed to the light can be removed in a composition transferring step by making it adhere to the material other than the base material, utilizing the tackiness of the unexposed portion, and can be reused. As a consequence the amount of the highly expensive unexposed portion which should be removed in the removing step will be rather small.

Further, accordingly, the amount of developing solution used in the removing step will also be small, and hence a spent solution can easily be replaced. Accordingly the employment of a liquid photopolymerizable composition has various advantages.

On the other hand, however, it is difficult for the composition to be applied to a base material in uniform thickness in a workshop and this work requires great skill. Further when the base material is deformed, it is very difficult for the composition to be applied even manually so. In these senses, the use of a liquid photopolymerizable composition, too, has disadvantages.

To overcome the disadvantages as described above, the technique as described in US—A— 4,087,182 has been proposed. However, that technique relates to a process for controlling the total thickness of a carrier film, a liquid photopolymerizable composition and a base material. The patent does not describe or suggest that the thickness of a liquid photopolymerizable composition can be uniformly controlled per se on an uneven surface of a base material.

It is an object of the present invention to solve the difficulties involved in the application of a liquid photopolymerizable composition to a base in a layer of uniform thickness, while retaining its merits and advantages from economical and processing viewpoints on the other hand.

To this effect, according to the present invention, there is provided a process for coating a liquid photopolymerizable composition onto a base material, wherein a substantially transparent, flexible carrier film is coated with the liquid photopolymerizable composition to uniform thickness, then the carrier film together with the photopolymerizable composition is transferred, and further the carrier film is pressed onto the base material in a state where the coated surface of the carrier film faces the base material, which is characterized in that the pressure at which the carrier film is pressed onto the base material is kept constant so that the uniformity of the thickness of the liquid polymerizable composition is maintained even if the surface of the base material to be coated has a deformed shape.

A carrier film according to the present invention must have such flexibility that the film can be easily deformed both in the machine direction and in the transverse direction with sufficiently small force. Further, the carrier film should be substantially transparent, and preferably should be easily peeled off from a photohardened resin of a liquid photopolymerizable composition.

Examples of carrier films suitable for the purposes of the present invention are films of polyethylene, polypropylene, polyacetate, polyvinyl chloride, polyvinyl alcohol, polyethylene terephthalate, polycarbonate, polystyrene, polyamide and copolymers of vinyl chloride and vinylidene chloride.

A polypropylene film is one suitable example because it has good characteristics. Thus it is easily peeled off from a photopolymerizable composition, acts as a barrier against oxygen, has a high transparency and has a refractive index value near that of the composition.

The liquid photopolymerizable composition according to the present invention is a conventional photopolymerizable composition which shows fluidity at room temperature, and whose viscosity generally is in the range of from 10 to 200,000 centipoises at room temperature. When the viscosity is too high, its fluidity will be insufficient and when the viscosity is lower than the range, the composition is too fluid. A range of viscosity of the composition of from 100 to 50,000 cps is preferable for a practical execution of the present invention.

As a preferred example of photopolymerizable resin composition to be used according to the present invention, there may generally be mentioned a composition comprising a prepolymer having a polymerizable ethylenically unsaturated group, optionally with a photopolymerizably unsaturated group, optionally with a photopolymerization sensitizer, a heat-polymerization inhibitor and/or an ethylenically unsaturated monomer as a cross-linking agent. As examples of the prepolymer, there may generally be mentioned polymerization products such as unsaturated polyesters, alkyd resins, unsaturated polyurethanes and oligomers of the ester-acrylate type. In the present invention, the prepolymers preferably have a number average molecular weight of 500 to 100,000.

(I) More illustrative examples of the above-mentioned prepolymers are given below:

1) Unsaturated polyesters prepared from at least one unsaturated dicarboxylic acid such as maleic acid, fumaric acid or itaconic acid, and/or its anhydride, and at least one polyhydric alcohol such as ethylene glycol, propylene glycol, diethylene glycol, triethylene glycol, glycerol, trimethylolpropane, pentaerythritol, 1,4-polybutadiene having terminal hydroxyl groups, hydrogenated or non-hydrogenated 1,2-polybutadiene having terminal hydroxyl groups, butadienestyrene copolymer having terminal hydroxyl groups or butadiene-acrylonitrile copolymer having terminal hydroxyl groups, and unsaturated polyesters prepared from at least one unsaturated dicarboxylic acid or its anhydride as mentioned above, and at least one saturated polycarboxylic acid or its anhydride such as succinic acid, adipic acid, phtalic acid, isophthalic acid, phthalic anhydride, trimellitic acid or trimellitic acid anhydride;

2) alkyd resins prepared by modifying the above-mentioned unsaturated polyesters with at least one drying oil and/or at least one semidrying oil;

3) unsaturated polyurethanes having addition-polymerizable unsaturated groups introduced by utilizing terminal isocyanate and/or hydroxyl groups of polyurethanes derived from at least one polyol having two or more terminal hydroxyl groups and at least one polyisocyanate, for example, unsaturated polyurethanes which are prepared from (i) a polyurethane having terminal isocyanate and/or hydroxyl groups and prepared from at least one polyol such as a polyhydric alcohol as mentioned above, polyester polyol or polyether polyol and at least one polyisocyanate such as tolylene diisocyanate, diphenylmethane-4,4'-diisocyanate or hexamethylene diisocyanate and (ii) at least one unsaturated mono- or dicarboxylic acid as mentioned above or its ester or polyester having active hydrogen atoms derived from hydroxyl (reactive with the terminal isocyanate) and/or carboxyl (reactive with both of the terminal isocyanate and the terminal hydroxyl) and/or amino groups (reactive with the terminal isocyanate), and unsaturated polyurethanes obtained by linking two or more molecules of an unsaturated polyester as mentioned above with a polyisocyanate; and

4) oligomers of an ester-acrylate type obtained by the condensation of an esterification reaction system composed of a polycarboxylic acid or its anhydride and a polyhydric alcohol with acrylic acid and/or methacrylic acid and having a number average molecular weight of about 200 to about 5,000, said number average molecular weight being controlled by choosing an appropriate molar ratio of the raw materials, examples of said polycarboxylic acid or its anhydride being adipic acid, isophtalic acid, phtalic and phthalic anhydride, examples of said polyhydric alcohol being ethylene glycol, propylene glycol, diethylene glycol, triethylene glycol, glycerol, trimethylolpropane and pentaerythritol; epoxyacrylates, for example, esters of acrylic acid or methacrylic acid and a compound having epoxy groups obtained by condensation polymerization of a polyhydric alcohol or polyhydric phenol with epichlorohydrin or an alkylene oxide; and polymers having, in their side chains, carbon-carbon double bonds capable of taking an active part in the addition polymerization reaction, for example, polymers obtained by reacting an unsaturated carboxylic acid or its anhydride with a polymer having hydroxyl groups such as polyvinyl alcohol or cellulose, polymers obtained by esterifying a polymer or a copolymer of acrylic acid or methacrylic acid having carboxyl groups with an unsaturated alcohol such as allyl alcohol, glycidyl acrylate or glycidyl methacrylate, a polymer obtained by reacting a copolymer containing maleic anhydride monomer units with allyl alcohol, a hydroxyalkyl acrylate and/or a hydroxyalkyl methacrylate, and polymers obtained by reacting a copolymer having glycidyl acrylate and/or glycidil methacrylate monomer units with acrylic acid and/or methacrylic acid.

5) In the present invention, prepolymers other than mentioned above may be employed. Examples of such prepolymers are unsaturated polyamides, unsaturated polyimides, unsaturated polyethers, unsaturated polyacrylates, unsaturated polymethacrylates, various rubbers and the like. Further, in the present invention, there may be employed, as the prepolymers, compounds having no ethylenic double bonds which may be photopolymerized by a mechanism not attributed to ethylenic double bonds.

(II) Examples of the ethylenically unsaturated monomer which may be optionally used as a cross-linking agent in the photopolymerizable resin composition, are the following known ethylenically unsaturated monomers:

1) unsaturated carboxylic acids such as acrylic acid and methacrylic acid, or esters thereof, for example, alkyl acrylate, alkyl methacrylate, cycloalkyl acrylate, cycloalkyl methacrylate, alkyl halide acrylate, alkyl halide methacrylate, alkoxyalkyl acrylate, alkoxyalkyl methacrylate, hydroxyalkyl acrylate, hydroxyalkyl methacrylate, aminoalkyl acrylate, aminoalkyl methacrylate, tetrahydrofurfuryl acrylate, tetrahydrofurfuryl methacrylate, alkyl acrylate, allyl methacrylate, glydicyl acrylate, glydicyl methacrylate, benzyl acrylate, benzyl methacrylate, phenoxy methacrylate, mono- or di-acrylate of alkylene glycol, mono- or dimethacrylate of alkylene glycol, mono- or di-acrylate of polyoxyalkylene glycol, mono- or dimethacrylate of polyoxyalkylene, trimethylolpropane triacrylate, trimethylolpropane trimethacrylate, pentaerythritol tetraacrylate, pentaerythritol tetramethacrylate;

2) acrylamides and methacrylamides, or derivatives thereof, for example, an acrylamide N-substituted with an alkyl or hydroxyalkyl group, a methacrylate N-substituted with an alkyl or hydroxyalkyl group, an acrylamide N,N'-disubstituted with alkyl and/or hydroxyalkyl groups, a methacrylate N,N'-disubstituted with alkyl and/or hydroxyalkyl groups, diacetone acrylamide, diacetone methacrylamide, N,N'-alkylene-bisacrylamide, and N,N'-alkylene-bis-methacrylamide;

3) allyl compounds such as allyl alcohol, allyl isocyanate, diallyl phthalate and triallyl cyanurate;

4) maleic acid, maleic anhydride and fumaric acid, and esters thereof, for example, mono- or di-alkyl maleate, mono- or di-alkyl fumarate, mono- or di-haloalkyl maleate, mono- or di-haloalkyl fumarate, mono- or di-alkoxyalkyl maleate, mono- or di-alkoxyalkyl fumerate; and

5) other unsaturated compounds such as styrene, vinyl toluene, divinyl benzene, N-vinyl carbazole and N-vinyl-pyrrolidone. They may be used either alone or in combination. When they are employed in combination, an azide compound may be incorporated into the ethylenically unsaturated monomers. Examples of such an azide compound are 4,4'-diazidostilbene, p-phenylenebisazido, 4,4'-diazidobenzephonone, 4,4'-diazidodiphenylmethane, 4,4'-diazido-chalcone, 2,6-di(4'-azidobenzal) cyclohexanone, 4,4'-diazidostilbene-α-carboxylic acid, 4,4'-diazidodiphenyl, disodium salt of 4,4'-diazidostilbene-2.2'-disulfonic acid and the like. The amount of the ethylenically unsaturated monomer which may be optionally incorporated into the above-mentioned prepolymer is usually 200 parts or less by weight per 100 parts by weight of the prepolymer.

(III) Various photopolymerization sensitizers as commonly used can be optionally employed in the photopolymerizable resin composition. Specific examples of such sensitizers include benzoin, benzoin ethyl ether, benzoin n-propyl ether, benzoin isopropyl ether, benzoin isobutyl ether, 2,2-dimethoxy-2-phenylacetophenone, benzophenone, benzil, diacetyl, diphenyl sulfide, eosin, thionine, 9,10-anthraquinone, 2-ethyl-9,10-anthraquinone, Michler's ketone [(4,4'-bis-(dimethylamino)] benzophenone and the like. They may be used either alone or in combination. The amount of any photopolymerizable sensitizer is such as will be effective for polymerization, i.e., 0.001 to 10% by weight based on the photopolymerizable resin composition.

(IV) Examples of the heat-polymerization inhibitor optionally employed in the photopolymerizable resin composition are hydroquinone, tert-butylhydroquinone, benzoquinone, 2,5-diphenyl-p-benzoquinone, picric acid, di-p-fluorophenylamine, p-methoxyphenol, 2,6-di-tert-butyl-p-cresol and the like. They may be used either alone or in combination. The amount of any heat-polymerization inhibitor is such as will be effective for inhibiting heat polymerization, i.e., 0.005 to 5.0% by weight based on the prepolymer or the total weight of the prepolymer and the ethylenically unsaturated monomer. Photopolymerizable compositions other than those mentioned above, for example, a composition comprising polyethylene, polythiol and a photopolymerization sensitizer as disclosed in GB—A—1,251,232 may also be employed in the present invention.

A base material according to the present invention is a material such as a plate, a sheet or a film to which the liquid photopolymerizable composition as described above is applied and made to adhere so as to exhibit substantial functions of the composition.

The base material may be a rigid material which has sufficient dimensional stability not to be deformed with human power, including a glass plate, a crystallized quartz plate, a metal plate, a laminated board clad with copper, a plastic plate and a ceramic plate, etc. or a flexible material which is easily bendable including a plastic film, a plastic sheet, a paper and a rubber sheet, etc.

A thickness of the liquid photopolymerizable composition on the carrier film is preferably in the range of from about 10 μm to about 2 mm, considering the purpose of the present invention that the composition is transferred from a carrier film to a base material. The carrier film being coated with the composition to uniform thickness according to the present invention means that generally a fluctuation of the thickness should be controlled within about 10% of the thickness.

Suitable means for applying the composition to a carrier film to uniform thickness include a doctor, an air doctor, a flexible blade, a knife, a reverse roller, a transfer roller and a curtain etc., and will commonly be selected depending upon the properties of the composition employed.

The pressure at which the carrier film is pressed to the base material according to the present invention is preferably in the range of from about 0.098 to 98 N/cm² (0.01 to 10 kp/cm²)-gauge. Fluctuation of the pressure is preferably controlled within about 10% of the predetermined pressure.

In order that the carrier film is pressed upon a base material at a predetermined pressure, a rigid pressing means is preferably employed. The pressing means is preferably made of an article which in cross-section has basically the shape of a square, a triangle or a polygon, or is fan-shaped, or is circular, including a portion of small radius of curvature, with the length of the article being larger than the transverse dimension of the carrier film.

The small radius of curvature is preferably in the range of from 0.1 to 5 mm. When the radius is larger than 5 mm, air bubbles are apt to be introduced into the liquid photopolymerizable composition during the lamination of the composition and the base material, and when the radius is smaller than 0.1 mm, the portion having the small radius of curvature will be ineffective.

The article is preferably made of a metal, a plastic, especially an engineering plastic or glass.

The exposure to light of the liquid photopolymerizable composition according to the present invention is carried out by irradiation with an actinic light through the carrier film and an image-bearing transparency located at the side away from the base material, as is common practice.

The source of light employed in the present invention is for example a high-pressure mercury lamp, an ultra-high-pressure mercury lamp, an ultraviolet fluorescent lamp, a metal halide lamp and a halogen lamp, a pulsed xenon lamp or a carbon arc lamp.

Using these sources of light, generally light having a wavelength of from 300 to 400 μm is effective and usually used for exposure of the composition although the wavelength valves or ranges employed depend specifically upon the sort of composition used.

In order to peel off a carrier film from a photohardened resin layer, a peel-off roller is preferably used. Instead, a peel-off bar may be used.

A suitable developing solution according to the present invention, with which unhardened areas of a liquid photopolymerizable composition are removed, is any solution which can easily dissolve or disperse the unhardened areas of the composition.

Examples of suitable developing solutions are weakly alkaline solution such as an aqueous solution of sodium borate, an aqueous solution of sodium carbonate; a dilute solution of an anionic or nonionic surface active agent; a ketone such as acetone, methyl ethyl ketone; an ester such as methyl formate, methyl acetate, ethyl acetate; a chlorinated hydrocarbon such as chloroform, trichloroethylene, trichloroethane, methylene chloride; an aromatic hydrocarbon such as benzene, toluene, xylene; an alcohol such as methanol, ethanol, isopropanol; a cellosolve such as methyl cellosolve. The choice of the particular composition to be employed will depend upon the photopolymerizable composition used.

As an electro conductor of the present invention, generally copper is used, but other electro conductive metals including gold and silver can be used instead.

As an etching solution for etching a plate of copper of the present invention, an aqueous solution containing from 40 wt.% to 45 wt.% of ferric chloride is employed.

A printed circuit board as described in the present invention is a board on which is provided an I.C. (integrated circuit), an electric resistance and an electric condenser, etc. and to be usually and extensively used in various fields of electronics, including computers, correspondence machines, television sets and radio sets.

A solder mask according to the present invention is provided on a printed circuit board in order to cover and protect areas other than those to be soldered, and to prevent the areas from being penetrated by solder on soldering and from becoming soldered.

A heat-resistant liquid photopolymerizable composition according to the present invention is a composition of which a polymerized and hardened layer cannot substantially be deformed or broken at the melting point of an electroconductible and easily fusible metal such as solder.

Illustrative examples of the heat-resistant liquid photopolymerizable composition are as follows:

I. A prepolymer:
1) unsaturated polyester alkyd resins, unsaturated polyurethanes, oligomers of the ester-acrylate type, and/or others [previous (I) 1) through 5)] as described above in the present Specification as examples of a prepolymer of the liquid photopolymerizable composition according to the present invention, or
2) a reaction product of an epoxy compound of bisphenol A type of F type with an acrylic acid or methacrylic acid, or

3) a reaction product of multivalent isocyanate with an acrylate or methacrylate having a hydroxyl group or others.

II. An ethylenically unsaturated monomer:
1) trimethylolpropane triacrylate, or
2) 2-hydroxyethyl methacrylate, or others.

III. A photopolymerization sensitizer:
various photosensitizers [previous (III)] as described above as examples of a photosensitizer of the liquid photopolymerizable composition according to the present invention.

IV. A heat-polymerization inhibitor:
optionally, various heat-polymerization inhibitors [previous (IV)] as described above as examples of a heat-polymerization inhibitor of the liquid photopolymerizable composition according to the present invention.

V. Additives:
1) an adhesive agent: phosphoric ester, or an organic acid, or others,
2) a fire retarding auxiliary agent: antimony trioxide, or others,
3) a pigment: various pigments exhibiting green or blue color, or others.

A transparent glass plate according to the present invention is a glass plate which transmits substantially not less than 50% of visible rays and has a distortion of an image of with 5% when the image is viewed through the glass plate. Most of the commercially available general-purpose transparent glass plates are suitable for the purpose.

A reflection preventing light-shielding screen according to the present invention is a screen which functions to reduce the reflection of rays on the surface having an image, by controlling the angle of incidence of rays which can pass through the screen generally within 50° to the perpendicular to the surface.

A suitable stripping solution for hardened resin obtained from the liquid photopolymerizable composition is methylene chloride. Besides, a mixture of ethylene chloride containing 5 to 10 wt.% of an alcohol such as ethanol can be employed. The use of organic solvent, such as methyl ethyl ketone, although possible, is not recommendable from the viewpoint of safety.

The method of coating a liquid photopolymerizable composition according to the present invention will now be described with reference to the accompanying drawings.

Fig. 1 is a vertical cross-sectional view showing a liquid photopolymerizable composition applied to a base material by a conventional method.

Fig. 2 is a vertical cross-sectional view showing a state of a photohardened resin which has been exposed to light through an image-bearing transparency by a conventional method.

Fig. 3 illustrates process steps wherein a liquid photopolymerizable composition is applied, a base material or board, exposed to light, whereby a photoresist image, a board having through-holes, etc. is formed or produced.

Fig. 4 (1) through (7) are cross-sectional views, illustrating variations of a base and wherein a printed circuit board having through-holes is produced from a board which has been clad with electro-conductive metal layers on both surfaces thereof and on the inner walls of through-holes.

Fig. 5 is a cross-sectional view showing a heat-resistant liquid photopolymerizable composition applied to the printed circuit board according to a conventional method.

Fig. 6 is a cross-sectional view showing the difference between a photohardened portion and an unhardened portion of a photopolymerizable composition when the composition which has been applied to a base is exposed to light through a mask film according to a conventional method.

Fig. 7 is a plan view showing a portion of one example of a circuit board.

Fig. 8 is a magnification of a portion of Fig. 7 designated by X and solidified solder around the circumference of a through-hole applied with the help of a solder mask formed on a base by a conventional method.

Fig. 9 is a magnified figure similar to Fig. 8 when soldering has been applied with a solder mask formed on a base according to the present invention.

Fig. 10 is a cross-sectional view corresponding to Fig. 6, wherein the composition has been applied to a base material according to the present invention.

Fig. 11 is a cross-sectional view showing one exemplary embodiment having through-holes in a base material as employed in the present invention.

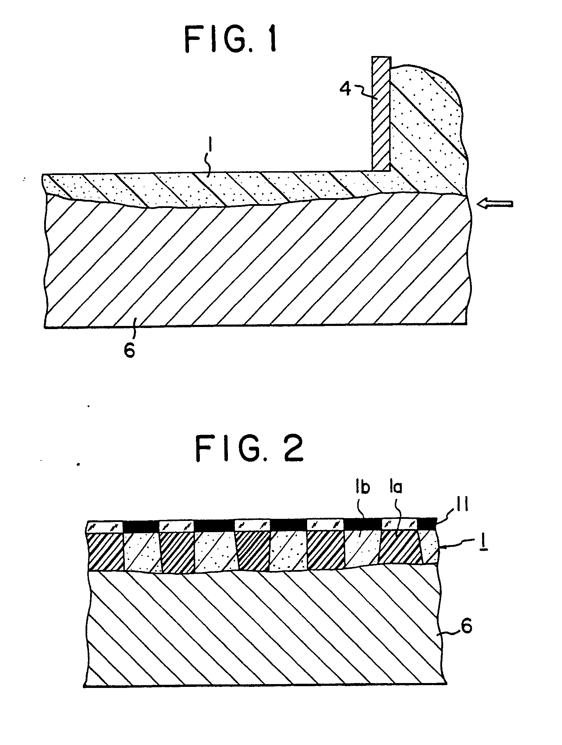

In Fig. 1 and 2, 6 is a base material (or a board), 1 is a liquid photopolymerizable composition coated on the base material 6, 4 is a means of controlling the thickness of the composition to be coated on the base material 6, such as a doctor, 11 is an image-bearing transparency (or a mask film).

In a conventional method of coating a liquid photopolymerizable composition onto a base material 6, the base has an uneven surface the composition 1 is coated on the base material by a composition spreading means, so that the surface of the composition becomes flat as shown in Fig. 1. Therefore, the thickness of the liquid photopolymerizable composition per se which has been coated on the base material 6 may not be constant or uniform.

When the layer of liquid photopolymerizable composition 1 is of non-uniform thickness applied to the base material as described above, exposure to actinic light through an image-bearing transparency (or a mask film) 11 will give unsatisfactory results. In fact, because the amount of energy to which it is exposed is uniform at any unit area of the composition, where there is a thin layer of liquid photopolymerizable composition the dimensions of the photohardened resin after exposure to the light at the surface of the base material 6 will be larger and where there is a thick layer of composition 1 the dimensions of the photohardened resin after exposure to the light will be smaller at the surface of the basic material 6, as shown in Fig. 2. As these phenomena show, this procedure will not always be satisfactory.

These effects are due to the fact that the thickness of the liquid photopolymerizable composition 1 to be coated on the base material 6 cannot be controlled to render it constant and uniform.

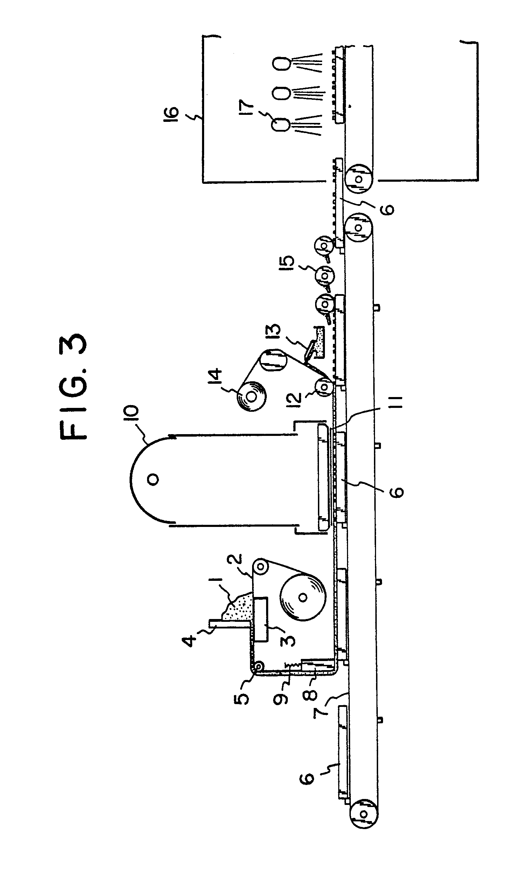

The present invention provides an improvement of the conventional methods as described above. One example of apparatus for carrying out the process according to the present invention is shown in Fig. 3.

In order to coat a liquid photopolymerizable composition 1 on a base material 6 by employing the apparatus of the present invention as shown in Fig. 3, first of all, a carrier film 2 is passed over a rigid plate 3 to make the film flat, and further the film is supplied to a winding roll 14, via a guide roll 5, a pressing means 8, a light exposure device 10 and a peel-off roll 12. A liquid photopolymerizable composition 1 is supplied on the carrier film 1 with the film facing the rigid plate 3, and further a base material 6 is supplied on a conveyor 7. The film 2 and the base material 6 are advanced substantially at the same velocity. Thus the composition 1 is coated onto the carrier film 2 in uniform thickness by a means 4 for controlling the thickness of the composition to be coated, such as a doctor or roll coater, and is then moved under a pressing means 8 via guide roll 5.

As the liquid photopolymerizable composition is usually a high, viscous material, having a viscosity in the range of from 10 to 200,000 c.p., the thickness of the composition is not thought to vary on the carrier film 2.

In this connection, as a pressing means 8, a rigid one, a means shaping a roll having substantially resilient surface and a usually used metallic roll which convert the moving direction of the carrier film 2 via a portion thereof having a small radius of curvature as shown in Fig. 3, are used. A spring 9 presses carrier film 2 to base material 6 through pressing means 8 at a predetermined pressure.

Thus, in a state where the coated surface of the carrier film 2 faces the base material 6, the film 2 is pressed to the base material 6 through pressing means 8 at a predetermined pressure. In this way, the thickness of the liquid photopolymerizable composition 1 coated on the base material 6 becomes uniform even if the surface of the base material 6 coated with the composition 1 is uneven to some extent or is not formed as a flat plate.

Thereafter, the laminate comprising composition 1 laminated on base material 6 to a predetermined uniform thickness and further the carrier film 2 superimposed upon the composition, is exposed to actinic light through an image-bearing transparency 11 in an exposing device 10, and a given portion of the composition 1 is photohardened. Further, as the carrier is being advanced, the carrier film 2 with most of unhardened liquid photopolymerizable composition 1 is adhering, is peeled off by a peel-off roller 12 from the base material 6 to which the photohardened resin 1 has become bonded closely. Then, as the carrier film is being further advanced, most of the unhardened composition 1 is removed by a main recovery device 13.

Furthermore, unhardened liquid photopolymerizable composition 1 adhered to the base material 6 from which the carrier film 2 has already been peeled off by a peel-off roller 12 is removed, as the base material is being advanced, by a subsidiary recovery device 15, e.g. an air-knife or an elastic roller. Thus, most of the remaining unhardened liquid photopolymerizable composition 1 is recovered by the subsidiary device 15. Then, the base material to which an image of photohardened resin has bonded is passed to a device for development 16, and where any remaining unhardened composition 1 on the base material is removed by a developing solution which is ejected from a nozzle 17. Thus, a base material on which a photoresist image is formed can be obtained.

The process according to the invention has thus been described for the case where one surface of a base material 6 is laminated with a liquid photopolymerizable composition 1. However, the process of the present invention is easily applicable to the case where a liquid photopolymerizable composition 1 is coated on both sides of a base material 6, by disposing a pressing means 8 as well as exposing devices 10, peel-off roller 12, winding rollers 14, main recovery devices 13 and subsidiary recovery devices 15 on both sides of a base material 6 and further by locating nozzles 17 at both the upper side and the down side of the base material 6.

In order to produce a printed circuit board by the process according to the present invention, a post treatment such as an etching or a metal plating process is further carried out by using the photoresist image produced as described above and by stripping the photoresist image with a stripping solution such as methylene chloride. Then, an excellent printed circuit board can be obtained.

A process for producing a printed circuit board by employing a photoresist image formed by the process according to the present invention, has various advantages, which can be described as follows.

(1) A liquid photopolymerizable composition can be employed even if the surface of a laminate clad with electro-conductive metal is coarse, the composition can sufficiently extend to concaved portions of the coarse surface, and hence the adherence of the composition to a base material is very high. Consequently, a printed circuit board having high resolving power can be obtained.

(2) As the photopolymerizable composition employed is a liquid type composition, even though dust or the like attaches to the base material, the composition will sufficiently adhere to the base material and will not form blisters on the base material, contrary to the case where a solid photopolymerizable composition is used.

Therefore, consequently, a highly reliable printed circuit board not having such defects as disconnection or bridging can be obtained.

(3) As the photopolymerizable composition employed is liquid, the composition can be coated onto, and made to adhere to, a base material as it is, and it is not necessary to heat both the composition and the material to make the composition adhere to the material, contrary to the case where a solid type composition, such as film, is made to adhere to a base material.

Further, the present invention does not require a holding time, which is generally required, when a solid type composition is adhered and laminated to the base material, in order to afford enough strength between the solid composition and the material.

Therefore, immediately after a liquid photopolymerizable composition has been applied or made to adhere on a base material, the composition can be exposed to light which forms an image of photohardened resin. Accordingly, the processing efficiency of the present invention is exceedingly high.

(4) As the photopolymerizing composition employed is a liquid type composition, the unhardened photopolymerizable composition not used to composition form an image of photohardened resin can be recovered and re-used. Further the composition can be provided and laminated in accordance with the size of a base material and by choosing a necessary portion thereof, and therefore a printed circuit board can be obtained at low cost.

The following examples are included merely to aid in the understanding of the present invention, and variations may be made by one skilled in the art without departing from the spirit and scope of the present invention.

### Example 1

By employing the apparatus according to the present invention as shown in Fig. 3, and employing a polypropylene film having a molecular weight of about 351,000 ('Alphan' produced by Honshu Seishi Co., Ltd.) having a thickness of 20 μm as a carrier film, and by advancing the film at a velocity of 50 mm/sec., a liquid photopolymerizable composition was coated onto the carrier film in a thickness of 55 μm on a rigid plate. The photopolymerizable composition had been obtained by dissolving and mixing 2 parts by weight of 2-ethylanthraquinone, 1.0 part by weight of mono-(methacryloxyloxyethyl)-phosphoric acid and 1.5 parts by weight of phtaloxyanine Green, to 100 parts by weight of a composition with 120 parts by weight of a composition consisting of 50 parts by weight of the reaction product of an epoxy compound of bisphenol A type and acrylic acid, 10 parts by weight of urethane methacrylate, 40 parts by weight of trimethylolpropane triacrylate and 20 parts by weight of 2-hydroxyethyl methylacrylate.

A base material consisting of a laminate of glass-reinforced epoxy resin clad with copper having a thickness of 0.8 mm on one surface (R1700, Matsushita Denko Co., Ltd.) was supplied at the same velocity as that of the carrier film by using a conveyor, and the liquid photopolymerizable composition was made to adhere to the base material of the laminate by employing a sponge roll as a pressing means.

The laminate was exposed to the light of an ultra-high-pressure mercury lamp in an amount of 120 mJ/cm$^2$ through an image-bearing transparency; the carrier film was peeled off from the laminate; and unhardened areas of the layer of the composition were removed with a developing solution of 1,1,1-trichloroethane, and then the copper layer was etched with aqueous solution containing from 40 wt.% to 45 wt.% of ferric chloride.

Thereafter, by stripping the photohardened resin an excellent printed circuit board having a line width of 60 μm, which we had desired to obtain, and which has no fatted line nor thinned line at etched parts thereof had been produced.

### Example 2

In the similar way as Example 1, by employing the apparatus according to the present invention as shown in Fig. 3, and employing a propylene film having a molecular weight of about 351,000 and having a thickness of 20 μm as a carrier film, and by making the film advance at a velocity of 70 mm/sec., a liquid photopolymerizable composition was coated to the carrier film in a thickness of 200 μm on a rigid plate. The photopolymerizable composition had been obtained by adding 12 parts by weight of diethylene glycol dimethacrylate, 30 parts by weight of tetraethylene glycol dimethacrylate, 6 parts by weight of diacetone acrylamide, 2 parts by weight of photosensitizer of benzoin isobutyl ether and 0.03 part of heat polymerization inhibitor of 4-tetrabutyl catechol, to 100 parts by weight of a prepolymer of unsaturated polyester having an acid value of 30 obtained by a condensation polymerization of propylene glycol, diethylene glycol, adipic acid, fumaric acid and isophthalic acid at a mole ratio of 0.12/0.38/0.24/0.14/0.12.

A base material in the form of a glass plate having thickness of 5 mm to be provided at the surface of a cathode-ray television tube was supplied at the same velocity as that of the carrier film by using a conveyor and the liquid photopolymerizable composition was made to adhere to the glass plate by employing a metallic bar having a radius of curvature of 0.3 mm in the path of movement of the carrier film as a pressing means.

The laminate obtained as described above was exposed to the light of an ultra-high-pressure mercury vapour lamp in an amount of 300 mJ/cm$^2$ through an image-bearing transparency, the carrier film was peeled off from the laminate, and unhardened areas of the layer of the composition were removed by spraying and washing, at a pressure of 9.8 N/cm² (1 kp/cm²) an aqueous solution of 40°C containing 1 wt.% of sodium borate and 0.5 st.% of nonionic surfactant (code no. D-3 produced by Sanyo Co., Ltd.) for 3 minutes, and followed by the steps of post-exposure, dyeing and drying.

Thus an excellent reflection preventing light-shielding screen for a cathode-ray television tube having a line width of 100 μm and a spacing between lines of 100 μm could be produced.

A process for producing a printed circuit board having through-holes will now be described briefly as follows.

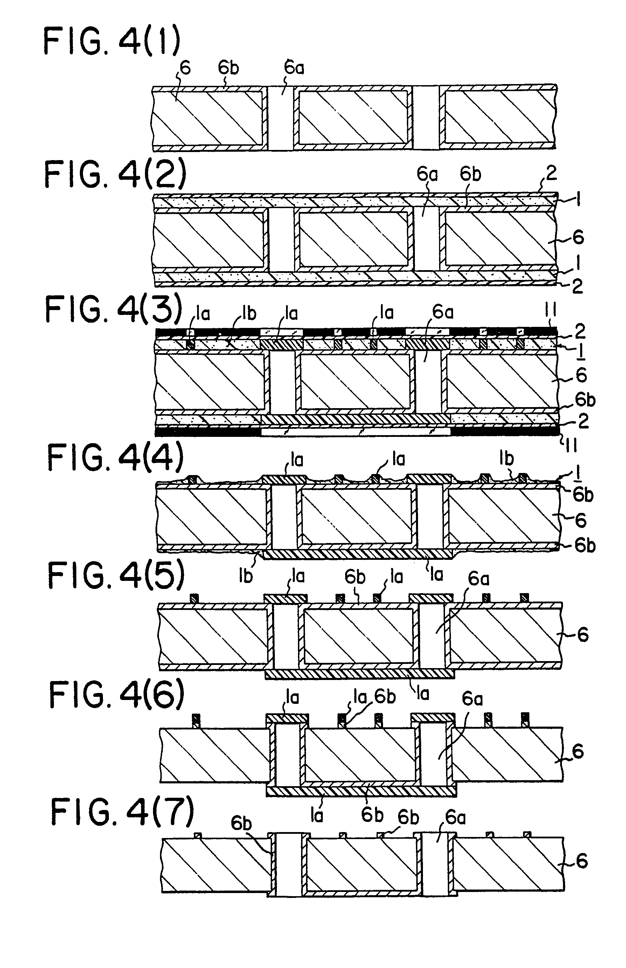

Fig. 4 is one exemplar, embodiment of a process for producing a printed circuit board having through-holes.

For forming an image of photohardened resin 1a which will be employed as a photoresist in etching, at openings or through-holes 6a and circumferences thereof on both surfaces of the base material of the board 6 and at desired parts of both surfaces of the board 6, by employing an apparatus having a structure as shown in Fig. 3, a process as described above for producing a printed circuit board by using a photoresist image is substantially wholly applicable.

Fig. 4(1) shows a base material 6 with an electro-conductive metal cladding on both surfaces of the material and on the inner walls of through-holes 6a. A liquid type photopolymerizable composition 1 is uniformly coated and laminated to predetermined thickness, as shown in Fig. 4(2). Then, after a mask film 11 being located on the carrier film 2, desired parts of the composition 1 are photopolymerized and hardened by exposure to an actinic light through the mask film, and thus an image of photohardened resin 1a is formed, as shown in Fig. 4(3).

Carrier film 2 is then peeled off, as shown in Fig. 4(4) and unhardened areas of the composition 1 are removed by a developing solution, as shown in Fig. 4(5). Thus an image of photohardened resin 1a can be formed which is located only at openings of through-holes and circumferences thereof on both surfaces of a base material 6 and at desired parts of both surfaces thereof.

Then, after removing a portion of the electro-conductive metal layer 6b which has not been masked by the image of photohardened resin 1a, by etching the base material 6 with an acid or alkaline solution, as shown in Fig. 4(6) and further by stripping the image of photoresist 1a with a stripping solution of methylene dichloride, a printed circuit board having through-holes can be obtained as shown in Fig. 4(7).

The process for producing a printed circuit board having through-holes has the following advantages in addition to what has been described above concerning a process for producing a printed circuit board by employing a photoresist image.

(1) In a process wherein a liquid photopolymerizable composition is coated onto a carrier film in uniform thickness and then the composition is made to adhere to and to be laminated on, a base material, the composition will not flow into the through-holes and can be uniformly laminated on the base material to a predetermined thickness, and thus no photohardened resin will remain in the through-holes when the image is stripped with a stripping solution.

(2) As the upper surface of the liquid photopolymerizable composition on the base material is covered with a carrier film, an image-bearing transparency can be directly laid on it, which facilitates processing.

A processing for producing a solder mask according to the present invention will now be described and compared with a conventional method and with reference to the drawings.

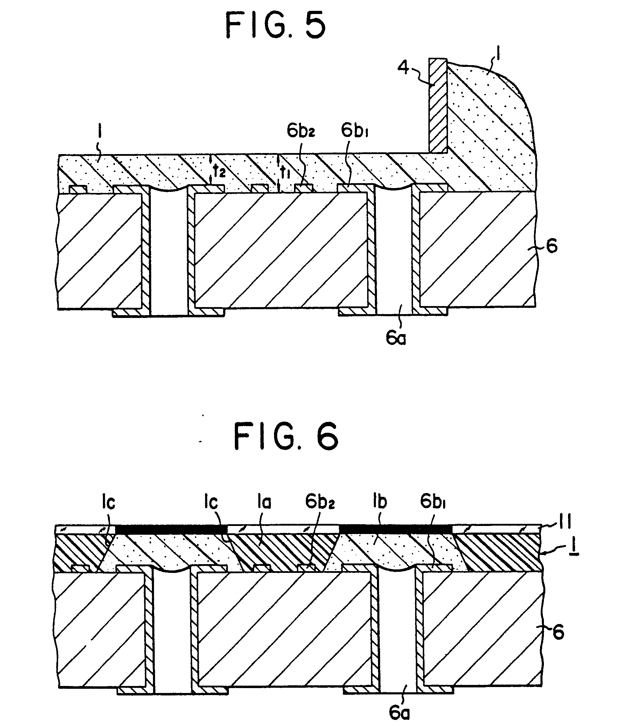

In a conventional method for applying a coating of photopolymerizable composition (hereinafter abbreviated as 'a liquid type composition') to a printed-circuit board 6 (hereinafter abbreviated simply as 'a board') this is fundamentally effected by a thickness controlling means so as to make the surface of the board plain and even, as shown in Fig. 5.

As shown, the board 6 has at through-holes 6a and at surfaces thereof an electro-conductive metal layer (hereinafter abbreviated as 'a land') $6b_1$ and an electro-conductive metal line (hereinafter abbreviated as 'a line') $6b_2$ which respectively constitute parts of a circuit, and hence the surface of the board is formed with projections and depressions accordingly, a layer of the liquid type composition coated onto the base material 6 by the conventional method is of non-uniform thickness ($t_1$: large, $t_2$: small) as shown in Fig. 5.

When the surface of the liquid type composition 1 is exposed to light in a state where the image of a mask film 11 is made to correspond to through-holes 6a in order to prevent the portions corresponding to a periphery of land $6b_1$ and the inner part thereof at or around through-hole 6a from being exposed to a light, the thickness of the coated composition is larger ($t_1$) just in the outer part of the periphery of through-hole 6a. Hence, the photohardened portion 1a by exposure to a light will fail to be formed truly as shown in Fig. 6. Therefore, a solder mask which can be obtained by removing unhardened areas of the composition will bare areas of the board outside the periphery of a land $6b_1$ of a through-hole 6a, as is shown by the position of a border line 1c between a photohardened portion 1a and an unhardened portion 1b in Fig. 6, to the extent that the mask often makes even a line $6b_2$ bare.

In this connection it should be noted that typical dimensions of some elements of a board are as follows; usually the width of a land $6b_1$ of a through-hole 6a is 200 μm, the width of a line is 100 μm, the pitch of through-holes 6a is 2.54 mm and the diameter of a through-hole is 0.5 mm or 0.7 mm.

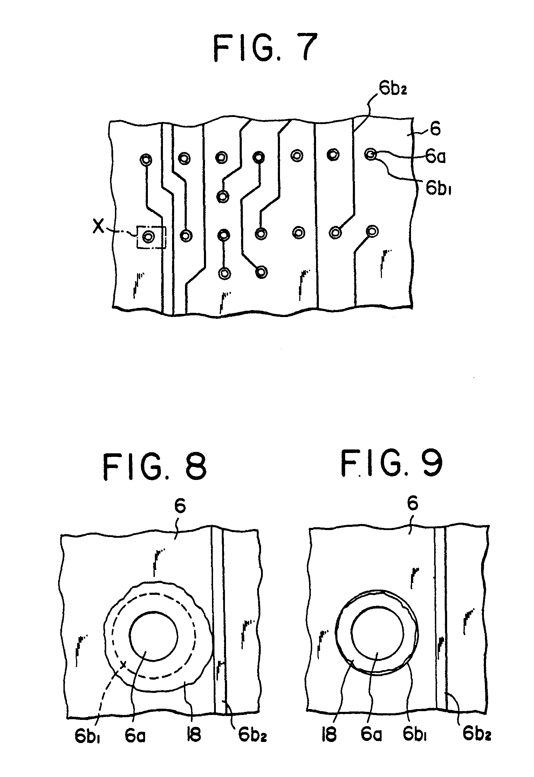

It is seen, therefore, that in the conventional method, when soldering is carried out on a board, for instance, as shown in Fig. 7 by forming a solder mask, a fused and fastened piece of solder 18 may make a bridge or a short-circuit in the nearest line $6b_2$ as shown in Fig. 8. To prevent such difficulties above, a certain secure distance is required between a land $6b_1$ and a line $6b_2$ of through-hole 6a, and so the number of circuits per unit distance must be reduced.

Further, when a part of the surface of a board which is photohardened by exposure to light has a depressed portion and a projecting portion, the degree of polymerization of the photohardened resin will become non-uniform, and hence a solder mask tends to form blisters because of the generation of air bubbles owing to heat of soldering. In order to repress such phenomena as described above, curing for 10 to 60 minutes at a temperature of from 100 to 200°C after exposure to light and removal of unhardened areas of photopolymerizable composition have been necessary.

Furthermore, a mask film 11 is designed to be placed directly on a liquid type composition 1 in Fig. 6, which generally, in the conventional method, makes re-use of a mask film 11 impossible and adjustment of its position difficult. On the other hand, keeping mask film 11 spaced from the liquid type composition 1 makes that part of the device more complicated, and the projection of the image of the mask film 11 will be unsharp.

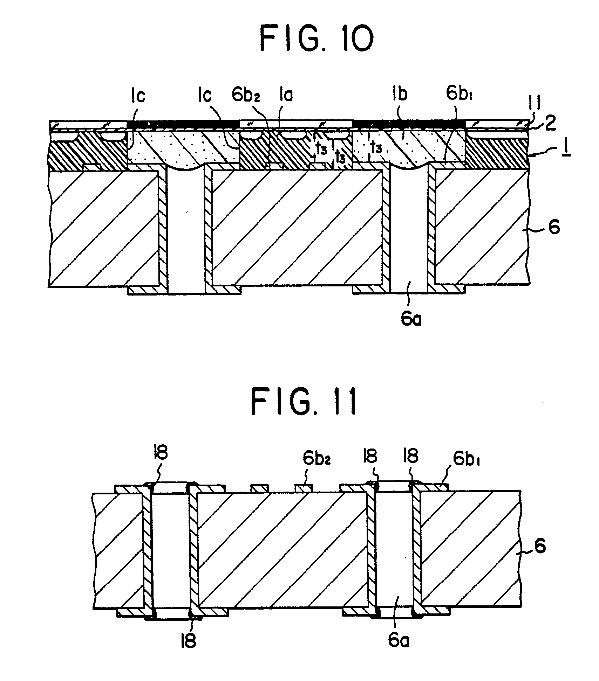

On the contrary, according to the present invention, by employing the apparatus as by way of example shown in Fig. 3, even if board 6 has an uneven surface such as at land $6b_1$ and line $6b_2$, the liquid type composition is made to adhere to the board 6 closely following the surface contours thereof by being pressed to the board. In this way, the thickness of the liquid type composition 1 on the board 6 will become constant and uniform, as is shown in Fig. 10.

Thereafter, the laminate comprising board 6, composition 1 and carrier film 2 is exposed to actinic light from a light 10 through a mask film 11 in an exposing device, and desired parts of the composition 1 are photohardened. As the thickness of the composition 1 was uniform $(t_3)$ throughout and projecting portions of the surface of the board 6, the photohardened resin 1a will have perpendicular borderlines 1c with unhardened parts 1b corresponding to the lines formed by the image of mask film 11.

Further, as mask film 11 does not stick to carrier film 2 even if placed directly on it as shown in Fig. 10, the position of the mask film on the carrier film can be easily and accurately adjusted by employing positioning means such as a hole for registration.

Furthermore, after finishing steps such as the step for removal and the drying step, as the thickness of the photopolymerizable composition is uniform $(t_3)$ according to the present invention, the degree of polymerization of the photohardened resin will be uniform, and hence a curing of the photohardened resin is not necessary. If necessary at all, only a short time would be required for curing. Thus, an excellent solder mask can be formed on the board 6.

Additionally, the process as described above can be applied in case the board already has soldered parts 18 on a land $6b_1$ of a through-hole 6a as shown in Fig. 11.

In order to solder the board 6 having a solder mask thus formed, in a state where some given parts are covered with protecting membranes, the terminals of parts are put into through-holes, and then they are soldered by dipping or flow-coating according to the conventional method. A fused and fastened state of solder 18 thus obtained is as shown in Fig. 9, wherein only a land $6b_1$ of a through-hole 6a is soldered accurately and no fear exists that the solder makes a bridge or short-circuit with line $6b_2$, for instance. It is effective in protecting the whole surface of board 6, especially in preventing erosion of a line $6b_2$, to leave the solder mask on the board 6.

The production of a solder mask according to the present invention has the following effects:

Firstly, the thickness of the liquid photopolymerizable composition can be made constant and uniform.

Secondly, it is easy for a mask film 11 to be accurately positioned on a carrier film.

Thirdly, unhardened parts 1b of the liquid photopolymerizable composition can remain correctly except the parts which correspond to an image of a mask film 11, and therefore fusing and fastening with solder 18 can be carried out accurately at predetermined positions employing a solder mask.

Fourthly, accordingly lines $6b_2$ can be disposed densely on board 6.

Fifthly, a solder mask can be obtained without blistering because of the generation of air bubbles.

Sixthly, as the liquid photopolymerizable composition 1 can spread to almost all parts and corners of depressed and projecting portions, of board 6, the whole surface except the parts to be soldered can be completely covered and projected.

Seventhly, even when a dust particle, for instance, is attached to board 6, the solder mask will not rise and float on the photohardened resin as can be observed in a solder mask using a solid photopolymerizable composition.

Eighthly, when the liquid type composition 1 adheres and is laminated to board 6, only one coat of the composition is sufficient, and additional heating and holding periods are not necessary. Thus, immediate exposure of the composition to light is possible, and accordingly productivity is extremely high.

Ninthly, as most of the unhardened part of the liquid type composition I can be recovered and reused and the areas of the composition to be applied can be selected to match the size of a board 6, contrary to a solid type photopolymerizable composition, the expensive material of the composition can be used with efficiency.

As described above, the process for coating a liquid photopolymerizable composition and processes for forming a photoresist image, for producing a printed circuit board having through-holes and for producing a solder mask according to the present invention has various advantages and therefore is of very high industrial benefit and value.

**Claims**

1. A process for coating a liquid photopolymerizable composition onto a base material, wherein a substantially transparent, flexible carrier film is coated with the liquid photopolymerizable composition to uniform thickness, then the carrier film together with the photopolymerizable composition is transferred, and further the carrier film is pressed onto the base material in a state where the coated surface of the carrier film faces the base material, characterized in that the pressure at which the carrier film is pressed onto the base material is kept constant so that the uniformity of the thickness of the liquid polymerizable composition is maintained even if the surface of the base material to be coated has a deformed shape.

2. A process according to claim 1, wherein the carrier film is peeled off from the photohardened resin of the composition after photo-exposure.

3. A process according to claim 2, wherein the carrier film is selected from the group consisting of a polyethylene film, a polypropylene film, a polyacetate film, a polyvinyl chloride film, a polyvinyl alcohol film, a polyethylene terephthalate film, a polycarbonate film, a polystyrene film, a polyamide film and a film of a copolymer of vinyl chloride and vinylidene chloride.

4. A process according to claim 1, wherein the base material is a rigid one.

5. A process according to claim 4, wherein the rigid base material is selected from the group consisting of a glass plate, a crystallized quartz plate, a metal plate, a laminated board clad with copper, a plastic plate and a ceramic plate.

6. A process according to claim 1, wherein the base material is a flexible one.

7. A process according to claim 6, wherein the flexible base material is selected from the group consisting of a plastic film, a plastic sheet, a paper and a rubber sheet.

8. A process according to claim 1, wherein the coating of the liquid photopolymerizable composition onto the carrier film is carried out by a means selected from the group consisting of a doctor, an air doctor, a flexible blade, a knife, a reverse roll, a transfer roll and a curtain.

9. A process according to claim 1, wherein for pressing the carrier film at a constant pressure to the base material, a rigid pressing means having a cross-section of small radius of curvature is used around which the moving direction of the carrier film is turned.

10. A process according to claim 9, wherein the small radius of curvature is in the range of from 0.1 to 5 mm.

11. A process according to claim 9, wherein the pressing means is made of an article the cross-section of which has basically the shape of a square, a triangle or a polygon, or is fan-shaped including a portion of small radius of curvature, the length of the article being larger than the transversal dimension of the carrier film.

12. A process according to claim 11, wherein the article is made of at least one material selected from the group consisting of metal, plastic and glass.

13. A process for producing a photoresist image, wherein after the liquid photopolymerizable composition is uniformly coated on the base material to uniform thickness according to claim 1, further (a) an image-bearing transparency is located on the carrier film, (b) the liquid photopolymerizable composition is photohardened imagewise by exposure to an actinic light through the transparency, and then, after the carrier film has (c) been peeled off from the photohardened resin layer, (d) unhardened areas of the photopolymerizable composition are removed with a developing solution, whereby the photoresist image is obtained.

14. A process according to claim 13, wherein the peeling off of the carrier film from the photohardened resin layer is carried out by a peel-off roll.

15. A process for producing a photoresist image in accordance with claim 13, wherein for producing a solder mask a printed circuit board is employed as the base material and a heat-resistant composition is employed as the liquid photopolymerizable composition.

16. A process for producing a printed circuit board having through-holes, wherein a liquid photopolymerizable composition is coated uniformly on the base material, according to claim 1, wherein (a) both surfaces of the base material, which surfaces as well as the inner walls of the through-holes have electroconductive layers thereon, are coated with the composition whereby both openings of the through-holes are covered with said composition like tents, (b) the liquid polymerizable composition on both sides of through-holes is photohardened imagewise by exposure to an actinic light through an image-bearing transparency, (c) and then, after the carrier films have been peeled off from the photohardened resin layers, unhardened areas of the layer of photopolymerizable composition are removed with a developing solution, the openings of the through-holes being covered with photohardened resin, and further, (d) using said images of photohardened resins as masks of the electroconductive layers, the unmasked layers of the electro-conductive layers are removed by etching, whereby a printed circuit board having images and through-holes is obtained.

17. A process according to claim 16, wherein the electro-conductive layers contain at least a copper layer.

18. A process for producing a reflection preventing light-shielding screen wherein a base material is coated in accordance with claim 1, wherein a transparent glass plate is employed as the base material and lines of hardened photopolymerizable resin are produced on it for restricting the angle of incidence of rays which can pass through the screen.

19. A process according to claim 13, which comprises, after exposure to light of the liquid photopolymerizable composition, instead of the use of a developing solution, a step of recovery of the unhardened portion of the composition, with a device for recovery from the carrier film, such as a doctor blade, and a subsidiary device for recovery from the base material, such as an air-knife or an elastic roller, this step following the step of peeling off of the carrier film.

### Patentansprüche

1. Verfahren zum Überziehen eines Basismaterials mit einer flüssigen photopolymerisierbaren Masse, bei dem man eine im wesentlichen transparente flexible Trägerbahn bis zu einer gleichmässigen Dicke mit der flüssigen photopolymerisierbaren Masse belegt, dann die Trägerbahn zusammen mit der photopolymerisierbaren Masse weiterbefördert und anschliessend die Trägerbahn derart auf das Basismaterial drückt, dass die belegte Oberfläche der Trägerbahn das Basismaterial bedeckt, dadurch gekennzeichnet, dass der Druck, mit dem die Trägerbahn auf das Basismaterial gedrückt wird, konstant gehalten wird, so dass die Gleichmässigkeit der Dicke der flüssigen polymerisierbaren Masse aufrechterhalten wird, sogar wenn die Oberfläche des zu überziehenden Basismaterials verformt ist.

2. Verfahren nach Anspruch 1, bei dem die Trägerbahn nach der Belichtung vom photogehärteten Harz der Masse abgezogen wird.

3. Verfahren nach Anspruch 2, bei dem die Trägerbahn aus der Gruppe gewählt wird, bestehend aus einer Polyäthylen-, Polypropylen-, Polyacetat-, Polyvinylchlorid-, Polyvinylalkohol-, Polyäthylenterephthalat, Polycarbonat-, Polystyrol-, Polyamidbahn und einer Bahn eines Copolymeren des Vinylchlorids und Vinylidenchlorids.

4. Verfahren nach Anspruch 1, bei dem das Basismaterial ein starres Material ist.

5. Verfahren nach Anspruch 4, bei dem das starre Basismaterial aus der Gruppe gewählt wird, bestehend aus einer Glasplatte, einer kristallisierten Quarzplatte, einer Metallplatte, einer kupferbelegten Schichtplatte, einer Kunststoffplatte und einer keramischen Platte.

6. Verfahren nach Anspruch 1, bei dem das Basismaterial ein flexibles Material ist.

7. Verfahren nach Anspruch 6, bei dem das flexible Basismaterial aus der Gruppe gewählt wird, bestehend aus einer Kunststoffolie, einer Kunststoffplatte, einer Papier- und einer Gummiplatte.

8. Verfahren nach Anspruch 1, bei dem das Belegen der Trägerbahn mit der flüssigen photopolymerisierbaren Masse durch ein Mittel vorgenommen wird, das aus der Gruppe gewählt wird, bestehend aus einer Rakel, einer Luftrakel, einem flexiblen Blatt, einem Messer, einer Umkehrwalze, einer Förderwalze und einem Schirm.

9. Verfahren nach Anspruch 1, bei dem zum Drücken der Trägerbahn bei konstantem Druck auf das Basismaterial ein starres Druckmittel mit einem Durchmesser mit geringem Krümmungsradius verwendet wird, um welches die Bewegungsrichtung der Trägerbahn gedreht ist.

10. Verfahren nach Anspruch 9, bei dem der geringe Krümmungsradius sich im Bereich von 0,1 bis 5 mm befindet.

11. Verfahren nach Anspruch 9, bei dem das Druckmittel aus einem Gegenstand hergestellt ist, dessen Querschnitt im wesentlichen rechteckig, dreieckig oder vieleckig oder fächerartig ausgebildet ist, einschliesslich eines Teiles des geringen Krümmungsradius, wobei die Länge des Gegenstandes grösser als die Querabmessung der Trägerbahn ist.

12. Verfahren nach Anspruch 11, bei dem der Gegenstand aus mindestens einem Material hergestellt ist, das aus der Gruppe gewählt wird, bestehend aus Metall, Kunststoff und Glas.

13. Verfahren zur Herstellung eines Photoresistbildes, bei dem man nach dem gleichmässigen Überziehen des Basismaterials mit der flüssigen photopolymerisierbaren Masse bis zu einer gleichmässigen Dicke nach Anspruch 1, weiter (a) ein bildtragendes Transparent auf der Trägerbahn anordnet, (b) die flüssige photopolymerisierbare Masse bildweise photohärtet, indem man sie durch das Transparent aktinischem Licht aussetzt und dann, nachdem die Trägerbahn (c) von der photogehärteten Harzschicht abgezogen worden ist, (d) ungehärtete Flächen der photopolymerisierbaren Masse mit einer Entwicklungslösung entfernt, wodurch das Photoresistbild erhalten wird.

14. Verfahren nach Anspruch 13, bei dem die Trägerbahn durch eine Abzugswalze von der photogehärteten Harzschicht abgezogen wird.

15. Verfahren zur Herstellung eines Photoresistbildes nach Anspruch 13, bei dem man zur Herstellung einer Lötmaske eine gedruckte Schaltung als Basismaterial und eine hitzebeständige Masse als flüssige photopolymerisierbare Masse verwendet.

16. Verfahren zur Herstellung einer gedruckten Schaltung mit Durchgangslöchern, bei dem das Basismaterial gleichmässig mit einer flüssigen photopolymerisierbaren Masse überzogen wird, nach Anspruch 1, bei dem man (a) beide Oberflächen des Basismaterials, welche Oberflächen ebenso wie die Innenwandungen der Durchgangslöcher mit elektrisch leitenden Schichten versehen sind, mit der Masse überzieht, wobei beide Öffnungen der Durchgangslöcher mit der genannten Masse zeltartig überdeckt werden, (b) die flüssige polymerisierbare Masse auf beiden Seiten der Durchgangslöcher bildweise photohärtet, indem man sie durch ein bildtragendes Transparent aktinischem Licht aussetzt (c) und dann, nachdem die Trägerbahnen von den photogehärteten Harzschichten abgezogen worden sind, ungehärtete Flächen der Schicht der photopolymerisierbaren Masse mit einer Entwicklungslösung entfernt, wobei die Öffnungen der Durchgangslöcher mit photogehärtetem Harz überdeckt werden und weiter (d) unter Verwendung der genannten Bilder photogehärteter Harze als Masken der elektrisch leitenden Schichten die unmaskierten Flächen der elektrisch leitenden Schichten durch Ätzen entfernt, wobei eine gedruckte Schaltung mit Bildern und Durchgangslöchern erhalten wird.

17. Verfahren nach Anspruch 16, bei dem die elektrisch leitenden Schichten mindestens eine Kupferschicht aufweisen.

18. Verfahren zur Herstellung eines Reflexion verhinderndes Lichtschutzschirmes, wobei ein Basismaterial gemäss Anspruch 1 überzogen wird, und bei dem man eine transparente Glasplatte als Basismaterial verwendet und Linien aus gehärtetem photopolymerisierbarem Harz darauf erzeugt, um den Einfallswinkel der Strahlen, die den Schirm passieren können zu beschränken.

19. Verfahren nach Anspruch 13, bei dem man, nachdem die flüssige photopolymerisierbare Masse Licht ausgesetzt worden ist, statt Verwendung einer Entwicklungslösung, den ungehärteten Teil der Masse zurückgewinnt, mit einer Vorrichtung zur Rückgewinnung von der Trägerbahn, wie ein Rakelmesser, und einer Hilfsvorrichtung zur Rückgewinnung von dem Basismaterial, wie ein Luftmesser oder eine elastische Walze, und zwar nach dem Abziehen der Trägerbahn.

## Revendications

1. Procédé de couchage d'une composition photopolymérisable liquide sur un matériau de base, où un film support sensiblement transparent, flexible, est couché avec la composition photopolymérisable liquide sur une épaisseur uniforme, et ensuite le film support avec la composition photopolymérisable est transféré, et de plus le film support est pressé sur le matériau de base à un état où la surface couchée du film support fait face au matériau de base, caractérisé en ce que la pression à laquelle le film support est pressé sur le matériau de base est maintenue constante, donc l'uniformité de l'épaisseur de la composition polymérisable liquide est maintenue même si la surface du matériau de base à coucher est déformée.

2. Procédé selon la revendication 1, où le film support est écaillé de la résine photodurcie de la composition après photo-exposition.

3. Procédé selon la revendication 2, où le film support est choisi dans le groupe consistant en un film de polyéthylène, un film de polypropylène, un film de polyacétate, un film de chlorure de polyvinyle, un film d'alcool polyvinylique, un film de téréphtalate de polyéthylène, un film de polycarbonate, un film de polystyrène, un film de polyamide et un film d'un copolymère de chlorure de vinyle et de chlorure de vinylidène.

4. Procédé selon la revendication 1, où le matériau de base est rigide.

5. Procédé selon la revendication 4, où le matériau rigide de base est choisi dans le groupe consistant en une plaque de verre, une plaque de quartz cristallisé, une plaque en métal, une plaque stratifiée plaquée de cuivre, une plaque en plastique et une plaque en céramique.

6. Procédé selon la revendication 1, où le matériau de base est flexible.

7. Procédé selon la revendication 6, où le matériau flexible de base est choisi dans le groupe consistant en un film plastique, une feuille plastique, un papier et une feuille de caoutchouc.

8. Procédé selon la revendication 1, où le couchage de la composition photopolymérisable liquide sur le film support est effectué par un moyen choisi dans le groupe consistant en une raclette, une raclette à air, une lame flexible, un couteau, un rouleau inverse, un rouleau de transfert et un rideau.

9. Procédé selon la revendication 1, où, pour presser le film support à une pression constante sur le matériau de base, un moyen rigide de pression ayant une section transversale d'un pétit rayon de courbure est utilisé, autour duquel tourne la direction de déplacement du film support.

10. Procédé selon la revendication 9, où le petit rayon de courbure est dans la gamme de 0,1 à 5 mm.

11. Procédé selon la revendication 9, où le moyen de pression est fait d'un article dont la section transversale a, à la base, la forme d'un carré, d'un triangle ou d'un polygone ou est en forme d'éventail comprenant une partie de petit rayon de courbure, la longueur de l'article étant plus grande que la dimension transversale du film support.

12. Procédé selon la revendication 11, où l'article est fait en au moins un matériau choisi dans le groupe consistant en métal, plastique et verre.

13. Procédé de production d'une image en vernis photosensible où, après avoir uniformément couché la composition photopolymérisable liquide sur le matériau de base, sur une épaisseur uniforme, selon la revendication 1, (a) une diapositive porteuse d'une image est de plus placée sur le film support, (b) la composition photopolymérisable liquide est photodurcie à la manière d'une image par exposition à une lumière actinique à travers la diapositive et ensuite, après avoir (c) écaillé le film support de la couche de résine photodurcie, (d) les zones non durcies de la composition photopolymérisable sont enlevées par une solution de développement, pour ainsi obtenir une image en vernis photosensible.

14. Procédé selon la revendication 13, où l'écaillement du film support de la couche de résine photodurcie est effectué par un rouleau d'écaillement.

15. Procédé de production d'une image en vernis photosensible selon la revendication 13, où, pour produire un masque de soudure, on emploie une plaque de circuit imprimé en tant que matériau de base et une composition thermorésistante est employée en tant que composition photopolymérisable liquide.

16. Procédé de production d'une plaque de circuit imprimé traversée de trous, où une composition photopolymérisable liquide est couchée uniformément sur le matériau de base, selon la revendication 1, dans lequel (a) les deux surfaces du matériau de base, lesquelles surfaces ainsi que les parois internes des trous ont des couches électroconductrices, sont couchées de la composition pour qu'ainsi les deux ouvertures des trous soient couvertes de ladite composition comme des tampons, (b) la composition photopolymérisable liquide des deux côtés des trous est photodurcie à la manière d'une image par exposition à une lumière actinique à travers une diapositive porteuse d'une image, (c) ensuite, après avoir écaillé les films supports des couches de résine photodurcies, les zones non durcies de la couche de la composition photopolymérisable sont enlevées par une solution de développement, les ouvertures des trous étant couvertes de la résine photodurcie et de plus (d) en utilisant lesdites images des résines photodurcies en tant que masques des couches électroconductrices, les zones non masquées des couches électroconductrices sont enlevées par attaque, et ainsi on obtient une plaque de circuit imprimé ayant des images et des trous.

17. Procédé selon la revendication 16, où les couches électroconductrices contiennent au moins une couche de cuivre.

18. Procédé de production d'un écran protégeant de la lumière et empêchant le réflexion où un matériau de base est couché selon la revendication 1, où une plaque en verre transparent est employée en tant que matériau de base et des lignes de résine photopolymérisable durcie sont produites dessus pour restreindre l'angle d'incidence des rayons pouvant traverser l'écran.

19. Procédé selon la revendication 13, qui comprend, après exposition à la lumière de la composition photopolymérisable liquide, au lieu de l'utilisation d'une solution de développement, une étape de récupération de la partie non durcie de la composition par un dispositif pour récupération du film support tel qu'une lame de raclette, et un dispositif subsidiaire pour récupération du matériau de base, comme un couteau à air ou un rouleau élastique, cette étape suivant l'étape d'écaillement du film support.

# FIG. 1

# FIG. 2

FIG. 3

0 099 426

FIG. 4(1)

FIG. 4(2)

FIG. 4(3)

FIG. 4(4)

FIG. 4(5)

FIG. 4(6)

FIG. 4(7)

# FIG. 5

# FIG. 6

# FIG. 7

6b₂
6
6a
6b₁
X

# FIG. 8

6

6b₁  6a  18  6b₂

# FIG. 9

6

18  6a  6b₁  6b₂

# FIG. 10

# FIG. 11